# FASCICULE DE BREVET EUROPEEN

(11) **EP 3 613 074 B1**
(45) Date de publication et mention de la délivrance du brevet: **22.06.2022**
(21) Numéro de dépôt: 18719983.1
(22) Date de dépôt: 16.04.2018
(51) Int. Cl.: H01L 21/60, G06K 19/077, H01L 23/498, H01L 21/50, D02G 3/44

(54) **PROCÉDÉ D'ASSEMBLAGE D'UNE PUCE MICROÉLECTRONIQUE SUR UN ÉLEMENT FILAIRE**
VERFAHREN ZUM VERBINDEN EINES MIKROELEKTRONISCHEN CHIPS MIT EINEM DRAHTELEMENT
METHOD FOR JOINING A MICROELECTRONIC CHIP TO A WIRE ELEMENT

(30) Priorité: 19.04.2017 FR 1753404
(43) Date de publication de la demande: 26.02.2020
(73) Titulaire: PRIMO1D, 38040 Grenoble Cedex 9 (FR)
(72) Inventeur: ROLLAND, Delphine, 38100 Grenoble (FR); MACKANIC, Christopher, 38240 Le Versoud (FR); ANDIA VERA, Gianfranco, 13013, Chateau Gombert Marseille (FR); ARENE, Emmanuel, 38330 Biviers (FR)
(74) Mandataire: IP Trust
(86) Numéro de dépôt international: PCT/FR2018/050955
(87) Numéro de publication internationale: WO 2018/193198

(56) Documents cités:
- EP-A1- 2 390 194
- EP-A1- 2 897 084
- EP-A2- 2 339 618
- EP-A2- 2 429 006
- WO-A1-2009/112644
- WO-A1-2014/041107
- WO-A2-2008/080245

## Description

La présente invention concerne un procédé d'assemblage d'une puce microélectronique sur un élément filaire. Elle trouve un exemple d'application dans le domaine de l'étiquetage électronique RFID (« Radiofrequency Identification » selon la terminologie anglo-saxonne) pour associer directement une antenne à une puce d'émission-réception et fournir un dispositif radiofréquence particulièrement petit en taille et simple de fabrication. Ce dispositif peut être intégré dans un fil textile et ce fil lui-même intégré à une grande variété d'objets pour leurs identifications, leurs suivis, et leurs administrations. Plus généralement, elle peut trouver son application dans tous les domaines pouvant bénéficier de l'intégration d'une puce électronique, tel qu'un capteur, un actionneur, une diode électroluminescente, ou une cellule solaire à un élément filaire tel qu'un fil textile ou un fil conducteur en vue de son intégration dans un objet.

Dans certains cas, la puce électronique pourra être connectée électriquement au fil lui-même conducteur électrique. Dans d'autres cas, le fil conducteur électrique pourra être couplé par induction à une inductance logée dans la puce électronique, sans contact électrique direct entre la puce et le fil. Dans un exemple ne faisant pas partie de l'invention, au moins un fil peut être de nature variée (pas nécessairement conducteur électrique) pourra assurer le maintien mécanique de la puce électronique comprenant un composant autonome (par exemple autoalimenté par une micro-capacité intégrée à ladite puce).

### ARRIERE PLAN TECHNOLOGIQUE DE L'INVENTION

On connaît par exemple des documents US8093617, US8471773, US8723312, US2015318409, US8782880, US8814054 ou US2015230336 la technologie d'assemblage d'un fil et d'une puce désignée par la dénomination commerciale E-THREAD^{™}.

Selon cette technologie, la puce est munie d'une rainure latérale et on insère une section longitudinale du fil dans cette rainure. L'assemblage peut être obtenu par encastrement du fil dans la rainure, les dimensions du fil et de la rainure étant alors suffisamment ajustées pour solidariser mécaniquement les deux éléments l'un à l'autre. L'assemblage peut également être obtenu ou renforcé par l'ajout d'une matière adhésive entre le fil et la puce, ou par soudure ou brasage du fil et de la puce.

Dans le document US8093617, la rainure latérale peut être notamment obtenue par l'assemblage de deux puces élémentaires comprenant chacune une petite base et une grande base parallèles reliées par au moins une face latérale inclinée ; l'assemblage des puces élémentaires par leurs petites bases permet de constituer la rainure latérale de la puce. Dans le document US2015230336, l'assemblage d'une puce et d'un capot fabriqué à base d'un empilement de couches électriquement isolantes permet également de former au moins une rainure latérale.

Les documents WO 2009/112644 A1 (figures 4-5), WO 2014/041107 A1 (figure 9), EP 2 429 006 A2 (figure 2) et EP 2 339 618 A2 (figures 2-10) divulguent des procédés selon le préambule de la revendication 1.

EP 2 390 194 A1 décrit un procédé pour assembler une puce sur un fil par insertion du fil dans une rainure présente dans la puce.

La formation de rainures par assemblage ou par gravure sur les faces latérales d'une puce est une opération délicate mais également contraignante en terme de configuration structurelle de la puce. Pour autant, l'absence de rainures au niveau de la puce rend difficile le positionnement précis des fils et leur assemblage fiable sur la puce, notamment dans un contexte industriel où il est nécessaire de tenir une cadence de fabrication importante.

### OBJET DE L'INVENTION

Un objet de la présente invention est de proposer une solution obviant tout ou partie des inconvénients de l'état de l'art. Un objet de l'invention est notamment de proposer un procédé d'assemblage d'une puce microélectronique sur un élément filaire, relaxant les contraintes sur la forme de la puce et permettant une fixation précise et fiable de l'élément filaire sur ladite puce.

### BREVE DESCRIPTION DE L'INVENTION

En vue de la réalisation de l'un de ces buts, l'objet de l'invention propose un procédé d'assemblage d'une puce microélectronique sur au moins un élément filaire conducteur électrique ; le procédé d'assemblage comprend :
- Une première étape d'application d'un capot sur une première face de la puce microélectronique, le capot étant configuré pour former avec la première face au moins une rainure temporaire latérale ;
- Une étape d'insertion de l'élément filaire dans la rainure temporaire ;
- Une étape de fixation de l'élément filaire sur la puce microélectronique ;
- Une étape de retrait du capot de la puce microélectronique.

Selon d'autres caractéristiques avantageuses et non limitatives de l'invention, prises seules ou selon toute combinaison techniquement réalisable :
- le capot comporte une face de contact appliquée sur la première face de la puce microélectronique et présentant au moins un épaulement pour former la rainure temporaire latérale avec ladite première face ;
- la face de contact appliquée sur la première face présente deux épaulements pour former deux rainures temporaires latérales parallèles, avec ladite première face ;
- la première face de la puce microélectronique présente au moins un épaulement, pour former la rainure temporaire latérale avec une face de contact du capot ;
- la première face de la puce microélectronique présente deux épaulements, pour former deux rainures temporaires latérales parallèles, avec la face de contact du capot ;
- la première étape d'application du capot sur la première face de la puce microélectronique comprend un maintien en contact entre la face de contact du capot et ladite première face, par dépression ;
- lors de l'étape d'insertion, une portion longitudinale de l'élément filaire est insérée au moins en partie dans la rainure temporaire latérale ;
- le procédé d'assemblage comprend une deuxième étape d'application d'un support sur une deuxième face de la puce microélectronique, pour rigidifier ladite puce microélectronique au moins pendant l'étape d'insertion de l'élément filaire ;
- la puce microélectronique comprend au moins un plot sur sa première face, localisé dans la zone formant un premier flan de la rainure temporaire quand le capot est appliqué sur la première face ;
- l'étape de fixation s'opère entre l'élément filaire et le plot ;
- le capot est formé en un matériau sur lequel le matériau dont est formé le plot n'adhère pas ;
- l'élément filaire et le plot comprennent au moins un matériau conducteur électrique ;
- l'étape de fixation comprend une séquence de chauffage localisé à proximité de la rainure temporaire, pour faire fondre le plot contre l'élément filaire ;
- le capot comprend un moyen de chauffage pour la mise en œuvre de la séquence de chauffage ;
- le capot est fixé à l'extrémité d'un bras articulé d'un dispositif de manipulation de puce ;
- le procédé d'assemblage comprend, après l'étape de retrait du capot, une étape de renforcement comportant la dispense d'un adhésif au moins sur une partie de l'élément filaire fixé sur la puce microélectronique ;
- le procédé d'assemblage comprend, après l'étape de retrait du capot, une étape d'encapsulation de la puce microélectronique et au moins de la portion longitudinale de l'élément filaire fixée sur ladite puce.

### BREVE DESCRIPTION DES DESSINS

D'autres caractéristiques et avantages de l'invention ressortiront de la description détaillée qui va suivre en référence aux figures annexées. Les figures sont des représentations schématiques qui, dans un objectif de lisibilité, ne sont pas nécessairement à l'échelle.
- la figure la présente une puce microélectronique compatible avec le procédé d'assemblage conforme à l'invention ;
- la figure 1b présente des capots amovibles, selon un premier mode de réalisation, compatibles avec le procédé d'assemblage conforme à l'invention ;
- la figure 1c présente une étape d'application d'un capot sur une puce microélectronique, du procédé d'assemblage conforme à l'invention ;
- la figure 2a présente une autre puce microélectronique et un capot amovible, selon un deuxième mode de réalisation, compatible avec le procédé d'assemblage conforme à l'invention ;
- la figure 2b présente une étape d'application d'un capot sur une puce microélectronique, du procédé d'assemblage conforme à l'invention ;
- la figure 3 présente une étape d'application d'un capot sur une puce microélectronique, du procédé d'assemblage conforme à l'invention ;
- les figures 4a et 4b présentent une étape d'insertion d'un élément filaire dans une rainure temporaire, du procédé d'assemblage conforme à l'invention, respectivement en vue en coupe et en perspective ;
- la figure 4c présente une étape d'insertion d'un élément filaire dans une rainure temporaire, du procédé d'assemblage conforme à l'invention ;
- la figure 5 présente une étape d'application d'un capot sur une puce microélectronique, du procédé d'assemblage conforme à l'invention ;
- les figures 6a, 6b et 6c présentent des variantes de l'étape de fixation d'au moins un élément filaire sur une puce microélectronique, du procédé d'assemblage conforme à l'invention ;
- la figure 6d présente une étape de retrait d'un capot, du procédé d'assemblage conforme à l'invention ;
- les figures 7a et 7b présentent des étapes complémentaires respectivement de renforcement et d'encapsulation d'un ensemble puce et élément filaire assemblé.

### DESCRIPTION DETAILLEE DE L'INVENTION

Par souci de clarté, seules les étapes et éléments utiles à la compréhension de l'invention ont été représentés et seront décrits. En particulier, les composants (d'émission-réception radiofréquences, par exemple) élaborés sur les puces microélectroniques n'ont pas été détaillés, l'invention étant compatible avec les dispositifs usuels (capteurs de mesure, identifiants d'objets, par exemple), en fonction de l'application visée. Les étapes de fabrication collectives des puces microélectroniques sur un substrat n'ont pas non plus été détaillées, l'invention étant là encore compatible avec des puces microélectroniques élaborées avec les techniques usuelles.

La figure la représente une puce microélectronique 1 (également désignée « puce » dans la suite de cette description) comprenant un composant microélectronique, compatible avec le procédé d'assemblage conforme à l'invention.

La puce microélectronique 1 comprend un substrat 3 comportant un composant microélectronique 4, tel qu'un circuit d'émission réception, un dispositif de calcul, un capteur, une LED ou tout autre forme de circuit intégré réalisé sur le substrat 3, par exemple à l'aide de techniques connues dans le domaine du semi-conducteur. Le composant microélectronique 4 se trouve sur la face supérieure de la puce 1, appelée première face 11 de la puce microélectronique 1. Pour protéger le composant microélectronique 4, une couche de protection est avantageusement disposée sur la surface du substrat 3.

La face inférieure de la puce 1 est appelée deuxième face 12.

Le composant microélectronique 4 peut être électriquement relié à une ou une pluralité de bornes de connexion 4a débouchant sur la première face 11 de la puce microélectronique 1, à l'aide de pistes ou de vias conducteurs formés sur ou dans le substrat 3. Alternativement, les bornes de connexion pourraient être présentes sur la deuxième face 12 de la puce 1.

Les figures, par souci de simplicité, représentent des puces 1 comportant deux bornes de connexion 4a sur leur première face 11 ; rappelons que la présence de ces bornes de connexion 4a est optionnelle.

Le procédé d'assemblage selon l'invention permet d'assembler la puce microélectronique 1 avec au moins un élément filaire 7a,7b.

L'assemblage de la puce 1 avec l'élément filaire 7a,7b peut avoir une fonction uniquement mécanique : l'élément filaire 7a,7b constitue alors un support mécanique pour la puce 1. Dans un tel cas de figure, il n'est pas utile de prévoir une ou des borne (s) de connexion 4a sur la première face 11 de la puce 1, l'élément filaire 7a,7b n'ayant pas vocation à établir un contact électrique avec la puce 1. L'élément filaire 7a,7b pourra être de nature quelconque, notamment textile, polymère, métallique, etc.

Alternativement, il peut être avantageux pour de nombreuses applications, de réaliser un contact électrique entre les bornes de connexion 4a de la puce 1 et l'élément filaire 7a,7b. Dans ce cas de figure, les bornes de connexion 4a sont avantageusement placées sur la première face 11 de la puce 1 et l'élément filaire 7a,7b est un conducteur électrique.

Selon encore une autre alternative, la puce microélectronique 1 peut être assemblée à deux éléments filaires 7a,7b, l'un conducteur électrique pour établir un contact électrique avec une borne de connexion 4a et l'autre de nature quelconque pour assurer un support uniquement mécanique de la puce 1.

L'élément filaire 7a,7b peut être de nature quelconque (sous réserve des cas de figure énoncés ci-dessus) dans la mesure où il est suffisamment résistant aux traitements mécaniques et potentiellement chimiques auxquels il est susceptible d'être exposé.

Notamment dans le cas de figure dans lequel on souhaite mettre en liaison électrique le fil avec une borne 4a du composant microélectronique 4 de la puce 1, l'élément filaire 7a,7b est un fil électrique conducteur, comme l'exige l'invention, par exemple en acier inoxydable ou en un alliage à base de cuivre ou en cuivre. L'élément filaire 7a,7b pourra encore être constitué par tout type de fibres textiles conductrices.

Le procédé d'assemblage comprend plusieurs étapes, et en premier lieu une étape d'application d'un capot 5 amovible sur une première face 11 de la puce microélectronique 1, le capot 5 étant configuré pour former avec la première face 11 au moins une rainure temporaire latérale 2a,2b, le long d'au moins une face latérale la, 1b de la puce microélectronique 1.

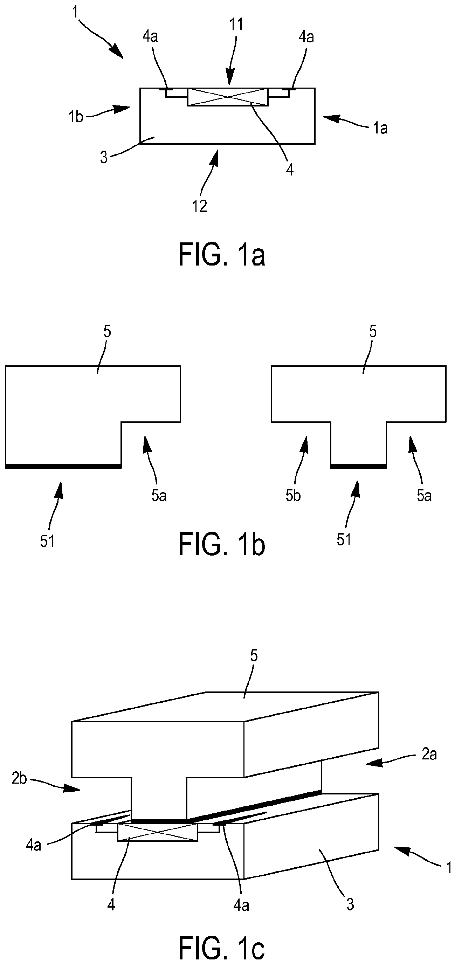

Selon un premier mode de réalisation, le capot 5 comporte une face de contact 51 destinée à être appliquée sur la première face 11 et présentant au moins un épaulement 5a,5b (figure 1b). Cet épaulement 5a,5b permet de former la rainure temporaire latérale 2a,2b avec la première face 11 de la puce microélectronique 1, lorsque le capot 5 est appliqué sur celle-ci (figure 1c). Selon ce mode de réalisation, la première face 11 est plane (ou sensiblement plane après les étapes de fabrication du composant microélectronique) et il n'est pas nécessaire de créer une rainure spécifique. Avantageusement, comme illustré sur la figure 1c, la face de contact 51 du capot 5, appliquée sur la première face 11 présente deux épaulements 5a,5b pour former deux rainures temporaires latérales 2a,2b parallèles, avec ladite première face 11 plane de la puce microélectronique 1.

Bien sur, la face de contact 51 du capot 5 pourra comporter un nombre quelconque d'épaulements, aptes à former des rainures temporaires, chacune disposée selon une orientation quelconque, sans sortir du cadre de l'invention.

La forme géométrique de la rainure 2a,2b n'est pas limitée à une forme générale parallélépipédique ; en effet, l'épaulement 5a,5b du capot 5 peut avoir la forme d'un créneau (figure 1b) mais également d'un biseau ou comporter un flan arrondi concave, ce qui peut générer une rainure 2a,2b de forme différente.

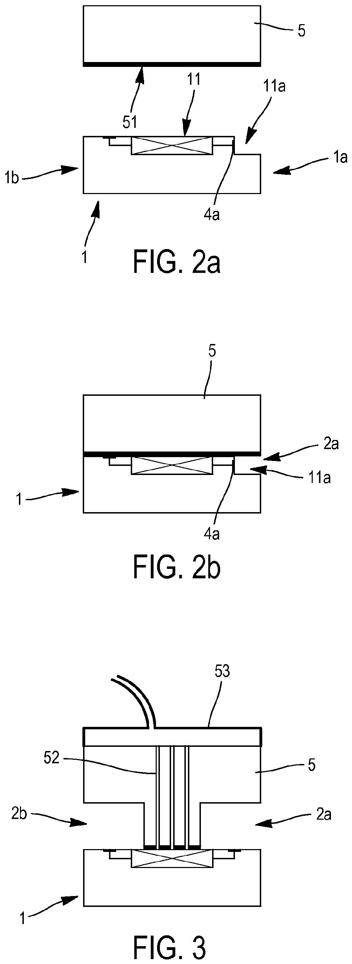

Selon un deuxième mode de réalisation de l'invention, illustré sur les figures 2a, 2b et 2c, le capot 5 comporte une face de contact 51 plane et la première face 11 de la puce microélectronique 1 présente au moins un épaulement 11a, pour former la rainure temporaire 2a latérale avec la face de contact 51 plane du capot 5. La borne de connexion 4a peut, dans ce mode de réalisation, être réalisée de manière à déboucher sur le premier flan, dans le plan de la première face 11, de l'épaulement 11a (non représenté) ou sur l'autre flan sensiblement vertical de l'épaulement 11a (comme illustré sur la figure 2b).

Selon une variante avantageuse (non représentée), la première face 11 de la puce microélectronique 1 présente deux épaulements le long de chacune de ses faces latérales 1a,1b, pour former deux rainures temporaires latérales 2a,2b parallèles, avec la face de contact 51 plane du capot 5.

Bien sur, la première face 11 de la puce 1 pourra alternativement comporter un nombre quelconque d'épaulements, aptes à former des rainures temporaires, chacune disposée selon une orientation quelconque.

Selon un troisième mode de réalisation (non représenté), le capot 5 et la puce 1 comportent chacun au moins un épaulement pour former au moins une rainure temporaire latérale 2a,2b lorsque le capot 5 est appliqué sur la première face 11 de la puce 1.

Les trois modes de réalisation exposés pour la mise en œuvre du procédé permettent de relaxer les contraintes de forme de la puce microélectronique 1 à assembler sur l'élément filaire 7a,7b, car il n'est pas nécessaire de former une rainure spécifique sur la puce elle-même. Selon le premier mode de réalisation, une puce 1 telle que sortie des étapes de fabrication du composant microélectronique est compatible. Selon les deuxième et troisième modes de réalisation, une gravure simple au niveau de la première face 11 est requise pour créer l'épaulement.

Dans la suite de la description et des figures, nous nous placerons dans le premier mode de réalisation énoncé. Les caractéristiques qui vont être exposées peuvent néanmoins s'appliquer à tous les modes de réalisation du procédé selon la présente invention.

L'étape d'application du procédé d'assemblage comprend avantageusement le maintien en contact entre la face de contact 51 du capot 5 et la première face 11 de la puce 1, par exemple par dépression. Pour cela, le capot 5 comprend au moins un canal 52 apte à relier sa face de contact 51 à un système d'aspiration 53 (figure 3). Le système d'aspiration 53 pourra par exemple comporter une pompe à vide. Mais l'invention n'est nullement limitée à ce mode de mise en œuvre, et toute technique permettant d'assurer le maintien du contact entre le capot 5 et la puce 1 peut convenir. Notamment, le capot 5 pourra être maintenu en contact avec la première face 11 de la puce 1 par la présence d'une substance à faible pouvoir adhésif sur sa face de contact 51.

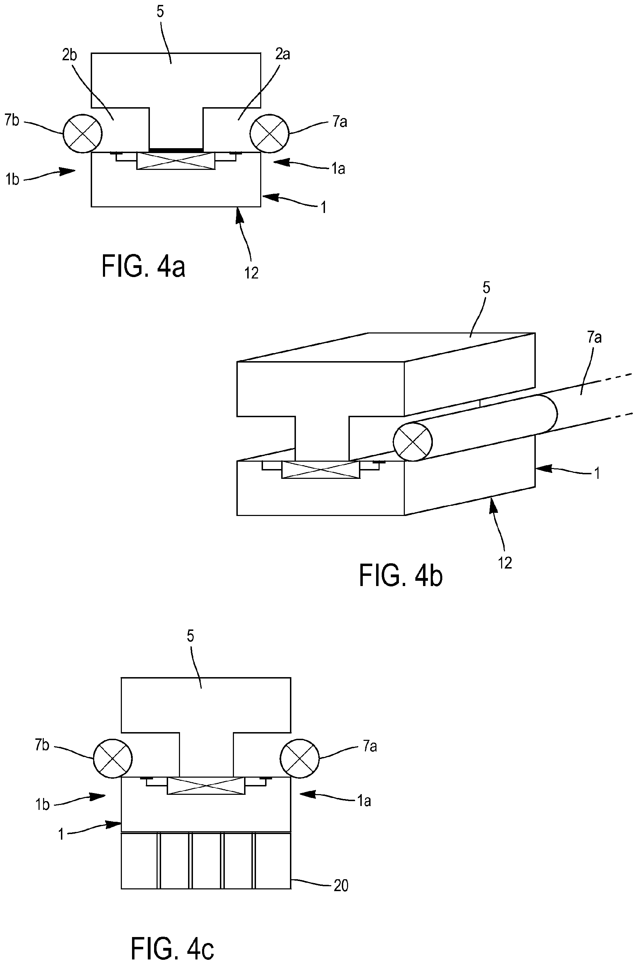

Le procédé d'assemblage selon la présente invention comprend ensuite une étape d'insertion de l'élément filaire 7a,7b dans la rainure temporaire 2a,2b, comme illustré sur les figures 4a et 4b. Lors de l'étape d'insertion, une portion longitudinale de l'élément filaire 7a,7b est insérée dans la rainure temporaire latérale 2a,2b.

Optionnellement, le procédé d'assemblage peut comprendre une deuxième étape d'application d'un support 20 sur la deuxième face 12 de la puce microélectronique 1, avant l'étape d'insertion. La présence du support 20 permet de soutenir et rigidifier la puce 1, au moins pendant l'étape d'insertion de l'élément filaire 7a,7b (figure 4c). Le support 20 pourra par exemple être maintenu en contact avec la deuxième face 12 de la puce 1 par aspiration, ou par la présence d'une substance à faible pouvoir adhésif, ou encore par la simple pression d'appui appliquée par le capot 5.

Selon l'invention, les dimensions en hauteur et en profondeur des rainures temporaires 2a, 2b, qui dépendent de la configuration structurelle du capot 5 (premier ou troisième mode de réalisation) et/ou de la configuration structurelle de la puce 1 (deuxième ou troisième mode de réalisation), sont choisies suffisamment grandes pour que chaque élément filaire à assembler puisse être logé dans une rainure temporaire 2a, 2b sans mécaniquement forcer son encastrement. Il est généralement préférable, pour favoriser la solidarisation de l'élément filaire 7a,7b à la puce 1, que la section longitudinale de l'élément filaire puisse être entièrement logée dans les rainures 2a,2b, c'est-à-dire que la portion logée de chaque fil ne déborde pas de la face latérale 1a,1b de la puce 1 au niveau de laquelle se trouve la rainure temporaire 2a,2b.

Lorsque une pluralité de rainures temporaires 2a, 2b, sont présentes, celles-ci ne sont pas nécessairement de mêmes dimensions. Similairement, les éléments filaires 7a,7b destinés à être logés dans les rainures temporaires 2a,2b ne sont pas nécessairement de même nature et ne présentent pas nécessairement des sections transversales de dimensions identiques.

Avantageusement, la puce microélectronique 1 comprend au moins un plot 6a, 6b sur sa première face 11, localisé dans la zone formant un premier flan de la rainure temporaire 2a,2b, quand le capot 5 est appliqué sur la première face 11. Ce plot 6a,6b, constitué d'un matériau de liaison, est destiné à fixer l'élément filaire 7a,7b sur la puce 1, lors de l'étape de fixation du procédé d'assemblage qui va être décrite dans la suite de la description.

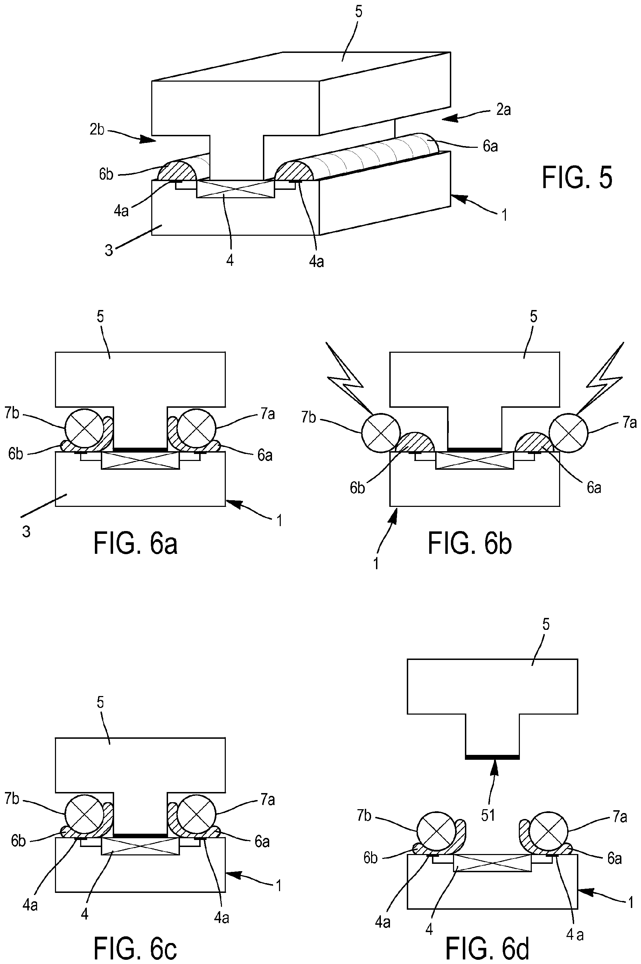

Dans l'exemple représenté sur la figure 5, les plots 6a, 6b sont disposés sur toute la longueur de la zone formant un premier flan de chaque rainure temporaire 2a,2b. De façon générale, le plot 6a,6b pourra s'étendre sur au moins une partie de la longueur du premier flan de la rainure temporaire latérale 2a,2b.

On pourra également choisir de constituer chaque plot 6a, 6b d'une pluralité de plots élémentaires, distincts les uns des autres, disposés sur une longueur plus ou moins étendue de la zone de la première face 11 formant un premier flan de la rainure temporaire 2a,2b.

Quelle que soient la forme, le volume, la disposition occupée par les plots 6a, 6b dans les rainures temporaires 2a, 2b, ceux-ci présentent avantageusement une dimension telle, qu'en leur présence il n'est pas possible de loger les éléments filaires dans les rainures temporaires 2a, 2b sans que les fils entrent en contact avec les plots 6a,6b. Chaque plot 6a, 6b forme une réserve d'un matériau de liaison qui permettra la fixation sur la puce 1, de l'élément filaire 7a,7b logé dans une rainure temporaire 2a, 2b.

Comme énoncé précédemment, selon un premier cas de figure, l'assemblage de la puce 1 sur l'élément filaire 7a,7b peut n'avoir qu'une fonction mécanique. Dans ce cas, le matériau de liaison formant les plots 6a,6b peut être une simple substance adhésive par exemple en polymère. Il peut s'agir d'une substance visqueuse, qui peut être traitée pour durcir au cours de l'étape suivante de fixation et ainsi assurer la solidarisation entre l'élément filaire 7a,7b et la puce 1.

Les plots 6a, 6b sont avantageusement déposés préalablement à l'étape d'application du capot 5 sur la première face 11 de la puce 1.

Selon un deuxième cas de figure, dans lequel on souhaite établir une connexion électrique entre la puce 1 et l'élément filaire 7a,7b, le matériau de liaison du plot 6a,6b est choisi parmi les matériaux conducteurs électriques. Il peut comprendre une pluralité de composés élémentaires. Il peut par exemple s'agir d'un alliage de métaux, par exemple d'étain, d'argent et de cuivre. Le matériau constituant chaque plot 6a, 6b est choisi pour que sa température de fusion soit relativement peu élevée. Cette température de fusion est inférieure à la température maximale à laquelle le composant microélectronique 4 de la puce 1 peut-être exposé sans être endommagé. Si, par exemple cette température maximale est de 350°C, on choisira le matériau des plots 6a, 6b pour que sa température de fusion soit inférieure à 350°C, par exemple 300°C. Avantageusement, pour des raisons de simplicité de mise en œuvre du procédé d'assemblage, ce matériau est choisi pour que sa température de fusion soit comprise entre 80°C et 100°C ou 150°C, ou 250°C. Par ailleurs, il n'est pas nécessaire que tous les plots 6a, 6b ou tous les plots élémentaires soient constitués du même matériau.

Les plots 6a, 6b peuvent être élaborés au cours de la fabrication de la puce 1, par exemple en les formant par dépôt sur le substrat 3, en contact avec les bornes de connexions 4a. Les plots 6a,6b sont avantageusement formés avant l'étape d'application du capot 5 sur la première face 11 de la puce 1.

Au cours de l'étape d'insertion, on dispose une portion longitudinale d'au moins un élément filaire 7a, 7b le long de la (au moins une) rainure temporaire 2a, 2b. On exerce alors des efforts limités sur l'élément filaire 7a, 7b pour le plaquer contre le plot 6a, 6b.

Le procédé d'assemblage selon l'invention comprend également une étape de fixation de l'élément filaire 7a,7b sur la puce microélectronique 1. D'une manière générale, l'étape de fixation met en œuvre un matériau de liaison ou une substance adhésive permettant de maintenir le contact entre l'élément filaire 7a, 7b et la puce 1, même lorsque le capot temporaire 5 n'est plus en contact avec la puce 1.

Ce matériau de liaison ou cette substance adhésive peut avoir été dispensé(e) avant l'application du capot 5 et l'insertion de l'élément filaire 7a,7b, comme précédemment énoncé, ou après ces étapes. Ainsi, l'étape de fixation peut se faire par injection d'une substance adhésive le long du fil à proximité de la première face 11 de la puce 1, après son insertion dans la rainure temporaire 2a,2b ; l'étape de fixation peut également prévoir l'application d'un matériau de liaison, par exemple par brasure.

Dans le mode de mise en œuvre préféré, le plot 6a, 6b a été préalablement constitué dans la rainure 2a, 2b. Comme cela est présenté sur la figure 6a, l'étape de fixation mène à la solidarisation de tout ou partie de la portion longitudinale de l'élément filaire 7a,7b insérée dans la rainure temporaire 2a,2b, sur la première face 11 par l'intermédiaire des plots 6a,6b.

Dans le premier cas de figure où les plots 6a,6b sont formés par une substance adhésive non encore durcie, ladite substance va s'affaisser lors de l'insertion de l'élément filaire 7a,7b et l'entourer partiellement. L'étape de fixation aboutit dès que la substance adhésive a durci de manière à assurer la solidarisation. Ce durcissement peut nécessiter de traiter la substance adhésive, par exemple par un rayonnement ultra-violet.

Le matériau constituant le capot 5 ou tout au moins le matériau disposé à la surface du capot 5 est choisi de manière à ce que la substance adhésive n'y adhère pas ou peu, afin d'éviter sa solidarisation au capot 5, ce dernier étant destiné à être retiré de la première face 11 de la puce 1.

Dans le deuxième cas de figure où les plots 6a,6b sont formés par un matériau conducteur, par exemple métallique, l'étape de fixation comprend une séquence de chauffage localisé à proximité de la rainure temporaire 2a,2b, pour faire fondre le plot 6a,6b contre l'élément filaire 7a,7b (figure 6b).

La séquence de chauffage peut être mise en œuvre avec un moyen de chauffage, par exemple un générateur de flux d'air ou d'un autre fluide chauffé, par induction, ou par une irradiation lumineuse telle qu'une irradiation laser ou un rayonnement ultra-violet, conduisant à générer un flux de chaleur définissant la zone chauffée au niveau de la puce 1. Le chauffage peut alternativement être obtenu par conduction thermique, par exemple en portant en température le capot 5 par l'intermédiaire de résistances chauffantes incorporées dans la masse de ce capot 5. Dans ce cas, le moyen chauffage est intégré au capot 5 lui-même.

Ainsi, on porte les plots 6a, 6b à une température de traitement supérieure à la température de fusion du matériau de liaison les composant, et pendant une durée suffisante pour le faire fondre. Le passage à l'état liquide du matériau de liaison, combiné aux efforts modestes de maintien contre la rainure temporaire 2a,2b, exercés sur l'élément filaire 7a, 7b conduit à l'enrobage partiel de ce dernier dans la rainure temporaire 2a, 2b comme cela est visible sur la figure 6c. Bien sur, il n'est pas nécessaire que le matériau de liaison des plots 6a, 6b passe dans sa totalité à l'état liquide pour provoquer cet enrobage partiel.

La séquence de chauffage terminée, une température inférieure à la température de fusion du matériau de liaison est restaurée, typiquement la température ambiante, ce qui conduit à redonner au matériau de liaison une constitution solide : l'élément filaire 7a,7b est rendu solidaire de la première face 11 et peut établir un contact électrique avec les bornes de connexion 4a de la puce 1.

Le capot est formé, dans ce deuxième cas de figure, en un matériau sur lequel le matériau conducteur du plot 6a,6b n'adhère pas afin d'éviter une adhésion dudit plot 6a,6b sur le capot 5, lequel est destiné, comme on l'a vu, à être retiré de la première face 11 de la puce 1. A titre d'exemple, le plot 6a,6b, déposé et fixé sur une borne de connexion 4a de la puce 1, pourra être composé d'un alliage de métaux, par exemple d'étain, d'argent et de cuivre. L'étape de fixation permet la solidarisation de l'élément filaire 7a,7b, par exemple constitué d'un acier inoxydable, d'un alliage à base de cuivre ou de cuivre, sur le plot 6a,6b. Le capot 5 pourra être composé d'un type de céramique, d'oxyde de silicium, d'un oxyde métallique ou alliage métallique par exemple revêtu de chrome, matériau sur lequel la brasure (matériau conducteur du plot 6a,6b) à base d'étain n'adhère pas.

Lorsque la puce 1 présente plusieurs rainures temporaires 2a, 2b pour accueillir plusieurs éléments filaires 7a, 7b, l'étape de fixation peut être réalisée successivement ou simultanément pour chacun des éléments filaires 7a,7b. La zone exposée à la température de traitement peut être suffisamment large pour englober au moins en partie tous les plots 6a, 6b. Alternativement, l'étape d'insertion peut comprendre l'exposition de plusieurs zones distinctes, simultanément ou successivement, chacune englobant une partie au moins des plots 6a, 6b.

Le procédé d'assemblage selon l'invention comprend enfin une étape de retrait du capot 5 de la puce microélectronique 1 (figure 6d), après l'étape de fixation qui vient d'être décrite. La face de contact 51 est alors séparée de la première face 11 de la puce 1. A titre d'exemple, l'étape de retrait peut comprendre l'interruption de la mise en dépression des canaux 52, ce qui fait cesser le contact par aspiration entre la face de contact 51 et la première face 1.

Le capot 5 peut être fixé à l'extrémité d'un bras articulé d'un dispositif de manipulation de puce tel qu'une machine automatique de « Pick and Place » selon la terminologie anglo-saxonne. Le bras articulé muni d'une buse d'aspiration pourra saisir une puce 1 dans une zone de stockage et la placer avec précision dans une position d'assemblage, par exemple sur un support 20, pour successivement opérer les étapes d'application puis de retrait du capot 5 vis-à-vis de la première face 11.

La présente invention met à profit les configurations respectives du capot 5 et de la puce microélectronique 1 pour former au moins une rainure temporaire 2a,2b dans laquelle un élément filaire 7a,7b peut être facilement et précisément positionné. La fixation de l'élément filaire 7a,7b sur la puce 1, par exemple par l'intermédiaire d'un plot 6a,6b disposé sur la première face 11 de la puce 1, permet la solidarisation et la tenue mécanique de l'ensemble puce / fil. Le capot 5 peut alors être retiré de la puce 1 et être appliqué sur une autre puce 1. Le procédé selon l'invention peut être répété et permettre l'assemblage d'une pluralité de puces microélectroniques 1 sur au moins un élément filaire 7a,7b, pour former une chaîne de puces 1.

Le procédé d'assemblage selon l'invention propose une solution relaxant les contraintes sur la forme de la puce (et en particulier sur la présence de rainures) et permettant une fixation précise et fiable de l'élément filaire 7a,7b sur la puce 1, du fait de la présence de la rainure temporaire 2a,2b.

Le procédé d'assemblage selon l'invention peut également comprendre des étapes complémentaires, après que le (s) élément(s) filaire(s) 7a, 7b ai(en)t été assemblé(s) à la puce 1 et le capot 5 retiré.

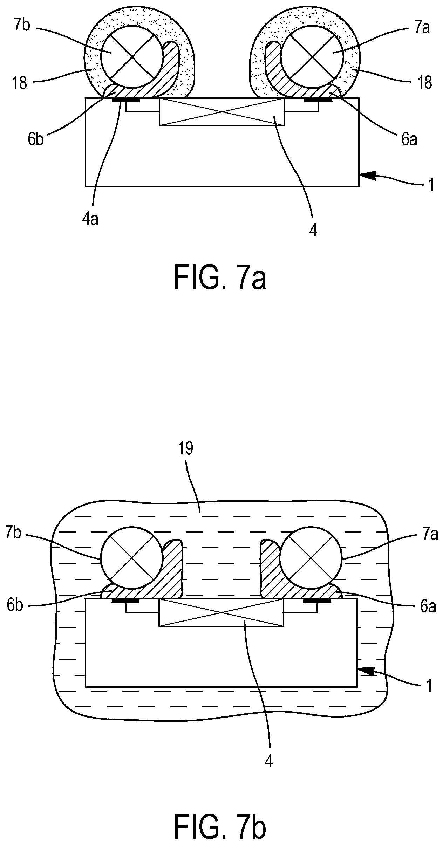

Ainsi, le procédé peut prévoir une étape de renforcement de l'assemblage formé par la puce 1 et le (ou les) élément(s) filaire(s) 7a, 7b. L'étape de renforcement peut comprendre la dispense d'un adhésif 18 au moins sur une partie de l'élément filaire fixé sur la puce microélectronique 1, comme illustré sur le figure 7a. La dispense de l'adhésif 18 peut être complétée par sa polymérisation, par exemple par traitement UV, qui peut être d'une durée très courte, de l'ordre de la seconde ou de quelques secondes, pour rigidifier l'adhésif et promouvoir sa solidarisation aux éléments avec lesquels il est en contact.

Le procédé peut également comprendre, comme étape complémentaire, une étape d'encapsulation de la puce microélectronique 1 et de la portion longitudinale de l'élément filaire 7a,7b fixé sur ladite puce, dans un matériau 19 suffisamment rigide et étanche, comme de la résine, permettant de protéger l'ensemble assemblé des sollicitations mécaniques ou chimiques dans son application finale (figure 7b). Préférentiellement, cette encapsulation est telle que toutes les faces de la puce 1 sont bien recouvertes du matériau encapsulant.

L'étape d'encapsulation peut être faite avec ou sans étape de renforcement préalable.

Le procédé peut également comprendre comme étape complémentaire, une étape de découpe de l'élément filaire 7a, 7b. Il peut s'agir de prélever un segment de la chaine, en vue de son intégration dans un objet. Il peut également s'agir de découper une portion de l'élément filaire 7a, 7b afin de former une antenne dipôle reliée à une puce 1 constituant un circuit d'émission réception comme cela est enseigné dans le document US8471773. La découpe de l'élément filaire 7a, 7b peut être réalisé par tous moyens connus en soi, par exemple à l'aide d'un outil mécanique de cisaillement ou par découpage laser.

Bien entendu l'invention n'est pas limitée au mode de mise en œuvre décrit et on peut y apporter des variantes de réalisation sans sortir du cadre de l'invention tel que défini par les revendications.

## Revendications

1. Procédé d'assemblage d'une puce microélectronique (1) sur au moins un élément filaire (7a,7b) conducteur électrique ; le procédé d'assemblage comprenant :
• Une première étape d'application d'un capot (5) sur une première face (11) de la puce microélectronique (1), le capot (5) étant configuré pour former avec la première face (11) au moins une rainure temporaire latérale (2a,2b) ;
• Une étape d'insertion de l'élément filaire (7a,7b) dans la rainure temporaire (2a,2b) ;
• Une étape de fixation de l'élément filaire (7a,7b) sur la puce microélectronique (1) ; le procédé d'assemblage étant **caractérisé en ce qu'**il comprend ultérieurement :
• Une étape de retrait du capot (5) de la puce microélectronique (1).

2. Procédé d'assemblage selon la revendication précédente, dans lequel le capot (5) comporte une face de contact (51) appliquée sur la première face (11) de la puce microélectronique (1) et présentant au moins un épaulement (5a,5b) pour former la rainure temporaire latérale (2a,2b) avec ladite première face (11).

3. Procédé d'assemblage selon l'une des revendications précédentes, dans lequel la première face (11) de la puce microélectronique (1) présente au moins un épaulement (11a), pour former la rainure temporaire latérale (2a) avec une face de contact (51) du capot (5).

4. Procédé d'assemblage selon l'une des deux revendications précédentes, dans lequel la première étape d'application du capot (5) sur la première face (11) de la puce microélectronique (1) comprend un maintien en contact entre la face de contact (51) du capot (5) et ladite première face (11), par dépression.

5. Procédé d'assemblage selon l'une des revendications précédentes, dans lequel, lors de l'étape d'insertion, une portion longitudinale de l'élément filaire (7a,7b) est insérée au moins en partie dans la rainure temporaire latérale (2a,2b).

6. Procédé d'assemblage selon l'une des revendications précédentes, comprenant une deuxième étape d'application d'un support (20) sur une deuxième face (12) de la puce microélectronique (1), pour rigidifier ladite puce microélectronique (1) au moins pendant l'étape d'insertion de l'élément filaire (7a,7b).

7. Procédé d'assemblage selon l'une des revendications précédentes, dans lequel la puce microélectronique (1) comprend au moins un plot (6a,6b) sur sa première face (11), localisé dans la zone formant un premier flan de la rainure temporaire (2a,2b) quand le capot (5) est appliqué sur la première face (11).

8. Procédé d'assemblage selon la revendication précédente, dans lequel l'étape de fixation s'opère entre l'élément filaire (7a,7b) et le plot (6a,6b).

9. Procédé d'assemblage selon l'une des deux revendications précédentes dans lequel le capot (5) est formé en un matériau sur lequel le matériau dont est formé le plot (6a,6b) n'adhère pas.

10. Procédé d'assemblage selon l'une des trois revendications précédentes, dans lequel, l'élément filaire (7a,7b) et le plot (6a,6b) comprennent au moins un matériau conducteur électrique.

11. Procédé d'assemblage selon l'une des quatre revendications précédentes, dans lequel l'étape de fixation comprend une séquence de chauffage localisé à proximité de la rainure temporaire (2a,2b), pour faire fondre le plot (6a,6b) contre l'élément filaire (7a,7b).

12. Procédé d'assemblage selon la revendication précédente, dans lequel le capot (5) comprend un moyen de chauffage pour la mise en œuvre de la séquence de chauffage.

13. Procédé d'assemblage selon l'une des revendications précédentes dans lequel le capot (5) est fixé à l'extrémité d'un bras articulé d'un dispositif de manipulation de puce.

14. Procédé d'assemblage selon l'une des revendications précédentes, comprenant, après l'étape de retrait du capot (5), une étape de renforcement comportant la dispense d'un adhésif (18) au moins sur une partie de l'élément filaire (7a,7b) fixé sur la puce microélectronique (1).

15. Procédé d'assemblage selon l'une des revendications précédentes, comprenant, après l'étape de retrait du capot (5), une étape d'encapsulation de la puce microélectronique (1) et au moins de la portion longitudinale de l'élément filaire (7a,7b) fixée sur ladite puce (1).

## Patentansprüche

1. Verfahren zum Montieren eines mikroelektronischen Chips (1) auf wenigstens einem elektrisch leitfähigen Drahtelement (7a, 7b); wobei das Montageverfahren Folgendes umfasst:
• einen ersten Schritt eines Anbringens einer Abdeckung (5) auf einer ersten Fläche (11) des mikroelektronischen Chips (1), wobei die Abdeckung (5) zum Ausbilden wenigstens einer temporären seitlichen Nut (2a, 2b) mit der ersten Fläche (11) konfiguriert ist;
• einen Schritt eines Einführens des Drahtelements (7a, 7b) in die temporäre Nut (2a, 2b);
• einen Schritt eines Fixierens des Drahtelements (7a, 7b) auf dem mikroelektronischen Chip (1); wobei das Montageverfahren **dadurch gekennzeichnet ist, dass** es anschließend Folgendes umfasst:
• einen Schritt eines Entfernens der Abdeckung (5) von dem mikroelektronischen Chip (1).

2. Montageverfahren nach dem vorhergehenden Anspruch, wobei die Abdeckung (5) eine Kontaktfläche (51) umfasst, die auf der ersten Fläche (11) des mikroelektronischen Chips (1) angebracht wird und wenigstens eine Schulter (5a, 5b) zum Ausbilden der temporären seitlichen Nut (2a, 2b) mit der ersten Fläche (11) aufweist.

3. Montageverfahren nach einem der vorhergehenden Ansprüche, wobei die erste Fläche (11) des mikroelektronischen Chips (1) wenigstens eine Schulter (11a) zum Ausbilden der temporären seitlichen Nut (2a) mit einer Kontaktfläche (51) der Abdeckung (5) aufweist.

4. Montageverfahren nach einem der beiden vorhergehenden Ansprüche, wobei der erste Schritt des Anbringens der Abdeckung (5) auf der ersten Fläche (11) des mikroelektronischen Chips (1) ein Aufrechterhalten einer Berührung zwischen der Kontaktfläche (51) der Abdeckung (5) und der ersten Fläche (11) durch einen Unterdruck umfasst.

5. Montageverfahren nach einem der vorhergehenden Ansprüche, wobei während des Schritts des Einführens ein Längsabschnitt des Drahtelements (7a, 7b) wenigstens teilweise in die temporäre seitliche Nut (2a, 2b) eingeführt wird.

6. Montageverfahren nach einem der vorhergehenden Ansprüche, das einen zweiten Schritt des Anbringens eines Trägers (20) auf einer zweiten Fläche (12) des mikroelektronischen Chips (1) zum Versteifen des mikroelektronischen Chips (1) wenigstens während des Schritts des Einführens des Drahtelements (7a, 7b) umfasst.

7. Montageverfahren nach einem der vorhergehenden Ansprüche, wobei der mikroelektronische Chip (1) wenigstens ein Kontaktstück (6a, 6b) auf seiner ersten Fläche (11) umfasst, das in dem Bereich angeordnet ist, der ein erstes Plättchen der temporären Nut (2a, 2b) ausbildet, wenn die Abdeckung (5) auf der ersten Fläche (11) angebracht wird.

8. Montageverfahren nach dem vorhergehenden Anspruch, wobei der Schritt des Fixierens zwischen dem Drahtelement (7a, 7b) und dem Kontaktstück (6a, 6b) stattfindet.

9. Montageverfahren nach einem der beiden vorhergehenden Ansprüche, wobei die Abdeckung (5) aus einem Material ausgebildet ist, auf dem das Material, aus dem das Kontaktstück (6a, 6b) ausgebildet ist, nicht klebt.

10. Montageverfahren nach einem der drei vorhergehenden Ansprüche, wobei das Drahtelement (7a, 7b) und das Kontaktstück (6a, 6b) wenigstens ein elektrisch leitfähiges Material aufweisen.

11. Montageverfahren nach einem der vier vorhergehenden Ansprüche, wobei der Schritt des Fixierens eine Erwärmungssequenz umfasst, die zum Schmelzen des Kontaktstücks (6a, 6b) an das Drahtelement (7a, 7b) in der Nähe der temporären Nut (2a, 2b) angeordnet ist.

12. Montageverfahren nach dem vorhergehenden Anspruch, wobei die Abdeckung (5) ein Erwärmungsmittel zum Ausführen der Erwärmungssequenz umfasst.

13. Montageverfahren nach einem der vorhergehenden Ansprüche, wobei die Abdeckung (5) an dem Ende eines Gelenkarms einer Chiphandhabungsvorrichtung fixiert ist.

14. Montageverfahren nach einem der vorhergehenden Ansprüche, das nach dem Schritt des Entfernens der Abdeckung (5) einen Schritt eines Verstärkens umfasst, der ein Aufbringen eines Klebstoffs (18) wenigstens auf einen Teil des Drahtelements (7a, 7b) umfasst, das auf dem mikroelektronischen Chip (1) fixiert ist.

15. Montageverfahren nach einem der vorhergehenden Ansprüche, das nach dem Schritt des Entfernens der Abdeckung (5) einen Schritt eines Einkapselns des mikroelektronischen Chips (1) und wenigstens des Längsabschnitts des Drahtelements (7a, 7b) umfasst, das auf dem Chip (1) fixiert ist.

## Claims

1. Method for joining a microelectronic chip (1) to at least one electrically conductive wire element (7a, 7b); the joining method comprising:
- a first step of applying a cover (5) to a first face (11) of the microelectronic chip (1), the cover (5) being configured to form at least one temporary side groove (2a, 2b) with the first face (11);
- a step of inserting the wire element (7a, 7b) into the temporary groove (2a, 2b);
- a step of attaching the wire element (7a, 7b) to the microelectronic chip (1);
the joining method being **characterized in that** it subsequently comprises:
- a step of removing the cover (5) from the microelectronic chip (1).

2. Joining method according to the preceding claim, wherein the cover (5) comprises a contact face (51) which is applied to the first face (11) of the microelectronic chip (1) and has at least one shoulder (5a, 5b) for forming the temporary side groove (2a, 2b) with said first face (11).

3. Joining method according to either of the preceding claims, wherein the first face (11) of the microelectronic chip (1) has at least one shoulder (11a) for forming the temporary side groove (2a) with a contact face (51) of the cover (5).

4. Joining method according to either of the two preceding claims, wherein the first step of applying the cover (5) to the first face (11) of the microelectronic chip (1) comprises maintaining contact between the contact face (51) of the cover (5) and said first face (11) by negative pressure.

5. Joining method according to any of the preceding claims, wherein, during the insertion step, a longitudinal portion of the wire element (7a, 7b) is inserted at least partially into the temporary side groove (2a, 2b).

6. Joining method according to any of the preceding claims, comprising a second step of applying a support (20) to a second face (12) of the microelectronic chip (1) so as to stiffen said microelectronic chip (1) at least during the step of inserting the wire element (7a, 7b).

7. Joining method according to any of the preceding claims, wherein the microelectronic chip (1) comprises at least one contact pad (6a, 6b) on its first face (11), which contact pad is located in the region which forms a first flank of the temporary groove (2a, 2b) when the cover (5) is applied to the first face (11).

8. Joining method according to the preceding claim, wherein the attaching step takes place between the wire element (7a, 7b) and the contact pad (6a, 6b).

9. Joining method according to either of the two preceding claims, wherein the cover (5) is formed from a material to which the material from which the contact pad (6a, 6b) is formed does not adhere.

10. Joining method according to any of the three preceding claims, wherein the wire element (7a, 7b) and the contact pad (6a, 6b) comprise at least one electrically conductive material.

11. Joining method according to any of the four preceding claims, wherein the attaching step comprises a sequence of localized heating near the temporary groove (2a, 2b) so as to melt the contact pad (6a, 6b) against the wire element (7a, 7b).

12. Joining method according to the preceding claim, wherein the cover (5) comprises a heating means for implementing the heating sequence.

13. Joining method according to any of the preceding claims, wherein the cover (5) is attached to the end of an articulated arm of a chip handling device.

14. Joining method according to any of the preceding claims, comprising, after the step of removing the cover (5), a reinforcing step comprising dispensing an adhesive (18) at least on a part of the wire element (7a, 7b) which is attached to the microelectronic chip (1).

15. Joining method according to any of the preceding claims, comprising, after the step of removing the cover (5), a step of encapsulating the microelectronic chip (1) and at least the longitudinal portion of the wire element (7a, 7b) attached to said chip (1).
